Europäisches Patentamt

European Patent Office

Office européen des brevets

(19)

(11) Publication number: **0 431 782 A1**

# (12) EUROPEAN PATENT APPLICATION

(21) Application number: **90312527.6**

(22) Date of filing: **16.11.90**

(51) Int. Cl.⁵: **C04B 35/00, H01L 39/24, B32B 18/00**

(30) Priority: **04.12.89 US 445385**

(43) Date of publication of application:
**12.06.91 Bulletin 91/24**

(84) Designated Contracting States:
**CH DE FR GB LI SE**

(71) Applicant: **MINNESOTA MINING AND MANUFACTURING COMPANY**
**3M Center, P.O. Box 33427**
**St. Paul, Minnesota 55133-3427 (US)**

(72) Inventor: **Budd, Kenton D., c/o Minnesota Mining and**
**Manufact. Co., 2501 Hudson Road, P.O. Box 33427**
**St. Paul, Minnesota 55133-3427 (US)**
Inventor: **Lorentz, Robert D., c/o Minnesota Mining and**
**Manufact. Co., 2501 Hudson Road, P.O. Box 33427**
**St. Paul, Minnesota 55133-3427 (US)**
Inventor: **Sexton, Joseph H., c/o Minnesota Mining and**
**Manufact. Co., 2501 Hudson Road, P.O. Box 33427**
**St. Paul, Minnesota 55133-3427 (US)**

(74) Representative: **Baillie, Iain Cameron et al**
**c/o Ladas & Parry Isartorplatz 5**
**W-8000 München 2 (DE)**

(54) **Flexible superconductor coated zirconia fibers.**

(57)  This invention provides a flexible composite article comprising a fiber core comprising crystalline zirconia and coated on at least a portion thereon a thin film comprising a high temperature ceramic oxide superconductor phase and methods to provide the same. High temperature ceramic oxide superconductors include $Y_1 Ba_2 Cu_3 O_7$, and $Bi_4 Sr_3 Ca_3 Cu_4 O_{16}$, and $Bi_2 Sr_2 Ca_1 Cu_2 O_8$.

EP 0 431 782 A1

# FLEXIBLE SUPERCONDUCTOR-COATED ZIRCONIA FIBERS

## Field of the Invention

This invention relates to zirconia fibers coated with a thin film comprising a high temperature ceramic oxide superconductor and methods for their preparation. The coated fibers are useful for applications which require the transport or storage of electrical energy.

## Background Art

High temperature ceramic oxide superconductors were first discovered in 1986 (see e.g., "The Development of High-$T_c$ Ceramic Superconductors : An Introduction", D.R. Clarke, Adv. Cer. Matl., 2, (38), Special Issue, 1987, pp. 273-292). In thin film form, electrical and mechanical properties of high temperature ceramic oxide superconductors are typically superior to those in bulk form. For example, it is known in the art that maximum critical current densities of high temperature ceramic oxide superconductors are higher for thin films than for bulk forms. Furthermore, magnetic fields have less effect on the critical current density of superconductor thin films than for bulk forms.

High temperature ceramic oxide superconductors are known in the art and include materials in such systems as Y-Ba-Cu-O, Bi-Sr-Ca-Cu-O, Tl-Ba-Ca-Cu-O, La(Sr, Ba)-Cu-O, as well as related materials.

It is known in the art to deposit high temperature ceramic oxide superconductors in bulk form onto rigid, planar ceramic oxide substrates. For example, the deposition of Bi-Sr-Ca-Cu-O thick films onto bulk MgO substrates is described by K. Hoshino et al. in "Preparation of Superconducting Bi-Sr-Ca-Cu-O Printed Thick Films on MgO Substrate and Ag Metal Tape", Jap. J. Appl. Physics, 27, (7), July, 1988, pp. L1297-L1299.

It is also known in the art to deposit thin films of high temperature ceramic oxide superconductors onto planar substrates. For example, R. B. Laibowitz in "High $T_c$ Superconducting Thin Films", M.R.S. Bull., Jan., 1989, pp. 58-62, discusses the deposition of high temperature ceramic oxide superconductors such as Y-Ba-Cu-O, Bi-Sr-Ca-Cu-O, and Tl-Ba-Ca-Cu-O onto wafer-shaped substrates such as $Al_2O_3$, MgO, $SrTiO_3$, Si, $LaGaO_3$, and $ZrO_2$ stabilized with Y.

Furukawa Electric Co. (Superconductor Week, 3, Feb. 6, 1989, p. 3) has made by known evaporation techniques a "superconducting tape-type conductor" which consists of a HASTELLOY™ -C-nickel based alloy carrier and a Y-Ba-Cu-O superconducting film with an intermediate copper stabilizing layer.

It is also known in the art to deposit high temperature ceramic oxide superconductor thin films onto metal filaments. For example, a superconductor wire made by hollow cathode sputtering alternating layers of a superconductor such as a Y-Ba-Cu-O compound, a La-Ba-Cu-O compound, or a La-Sr-Cu-O compound and a ductile metal such as copper onto a high strength core filament such as tungsten is disclosed in EP 0290127A2.

E.J.A. Pope et al. in "Organometallic Polymer Route to Superconducting Ceramics : Chemistry and Fabrication of Wires and Coatings", M.R.S. Extended Abstracts High-Temperature Superconductors II, Fall, 1988, pp. 97-100, reported a method for dip-coating platinum filaments with organometallic Y-Ba-Cu-O precursors. The authors did not, however, report observing superconductivity.

It is also known in the art to deposit high temperature ceramic oxide superconductor thin films onto non-oxide ceramic fibers. For example, EP 0303412A2 describes a process for making a superconducting composite comprising a low resistivity, high strength, ultra high modulus, carbon fiber with a ceramic high temperature superconductor such as $A_1B_2Cu_3O_{7-x}$ (wherein A is Y, La, or other element from the lanthanide group, B is a Group IIA element, and X is between 0 and 1) coated thereon. Also, EP 0318651A discloses a flexible superconductor consisting of a SiC carrier with a superconductive ceramic oxide sheath deposited onto the carrier by a thin film technology such as sputtering. The carrier is precoated with a layer of Cu, Al, or other stabilizing material, and a layer of perovskite of the general formula $ABO_3$ (e.g. $SrTiO_3$) prior to the deposition of the high temperature ceramic oxide superconductor.

M. Dietrich et al. in "High Field NbN Superconductor on a Fiber Basis", IEEE Trans. on Mag., MAG-23, (2), March, 1987, pp. 991-994, describes planar magnetron sputtering of a NbN superconductor thin film onto a carbon fiber or bundle thereof.

Zirconia fibers have been disclosed, for example, in U.S. Patent Nos. 3,385,915, 3,860,529, 3,180,741, 3,322,865, 3,992,498, and U.K. Patent Nos. 1,030,232, 1,360,197, and U.S.S.N. 07/286,654.

## Summary of Invention

Briefly, the present invention provides a composite article comprising a fiber core comprising crystalline zirconia and deposited on at least a portion thereof a thin film comprising a high temperature ceramic oxide superconductor.

The composite article of the present invention can be prepared by providing a fiber comprising zirconia and coating thereon a high temperature ceramic oxide superconductor or a precursor thereof. Where a precursor is used, it is heated in an oxidizing atmosphere for a time and at a temperature sufficient to provide a high temperature ceramic oxide superconductor. The precursor can be coated and heated simultaneously or sequentially. The preferred heat treating temperature is in the range of 400 to 1000°C.

The high temperature ceramic oxide superconductor-coated fiber of the present invention can vary in flexibility depending upon the thin film thickness and the fiber core diameter.

Zirconia and high temperature ceramic oxide superconductor thin films are chemically, crystallographically, and thermally compatible. That is to say, zirconia has lattice parameters (i.e., atomic spacing) and a crystal structure which can promote the formation of a high temperature ceramic oxide superconductor phase. Diffusion of chemical species between the zirconia and the high temperature ceramic oxide superconductor are not sufficient to substantially affect the superconductor properties, strength, or flexibility of the composite, and the thermal expansion coefficients of the zirconia and the high temperature ceramic oxide superconductor are sufficiently similar to prevent cracking or spalling during heating or cooling.

In this application :

"flexible" means capable of withstanding small-radius bends without breaking ;

"zirconia fiber" means a fiber or wirelike embodiment comprising preferably at least 75 volume percent of a doped or undoped crystalline zirconia phase(s), more preferably at least 90 volume percent of a doped or undoped crystalline zirconia phase(s), and most preferably at least 95 volume percent of doped or undoped crystalline zirconia phase(s), wherein the preferred crystalline zirconia phase(s) is cubic, tetragonal, or both ; wherein other metal oxides which can be useful as phase stabilizers can be present as dopants, wherein the dopant(s) is in solid solution within the crystalline zirconia phase(s) and can be present up to 20 mole percent ; and wherein other metal oxides which may be useful as grain growth inhibitors or tougheners can be present as separate phase(s) comprising up to 25 volume percent of the fiber ;

"solid solution" means a single crystalline phase which may be varied in composition within finite limits without the appearance of an additional phase ;

"bundle" or "tow" means of two or more fibers ;

"thin film" means a layer having a thickness not greater than 100 micrometers ;

"superconductor" means a material which has zero electrical resistance below a critical temperature ;

"onset temperature" means temperature at which at least a part of a material becomes superconducting ;

"high temperature ceramic oxide superconductor" means a ceramic oxide material comprising at least one oxide phase which exhibits superconductivity above 23 K ;

"deposit" means coating a high temperature ceramic oxide superconductor or precursor thereof onto a substrate ; where a high temperature ceramic oxide precursor is used, "deposit" also means heating the coated precursor for a time and at a temperature sufficient to convert the precursor into a high temperature ceramic oxide superconductor after or simultaneously with the coating step.

"current density" means electrical current per cross-sectional area.

The art does not disclose or suggest a flexible composite comprising a high temperature ceramic oxide superconductor-coated, crystalline zirconia fiber core or a method for making the same.

Detailed Description of the Preferred Embodiments

The preferred composite article of the present invention comprises a flexible, polycrystalline, silicon-free, carbon-free zirconia fiber core preferably having a diameter in the range of 5 to 60 micrometers and having a tensile strength greater than 0.5 GPa, wherein at least a portion of the fiber core is coated with a thin film comprising a high temperature ceramic oxide superconductor and wherein the thickness or diameter of the composite can be up to 100 micrometers, preferably in the range of greater than 5 micrometers to 60 micrometers.

A method for preparing zirconia fibers useful to make the articles of the present invention is disclosed in assignee's copending patent application Serial No. 07/286,654 which is incorporated herein by reference. As disclosed therein, a preferred process involves making a ceramic fiber containing crystalline zirconia grains comprising the steps of :

(a) mixing crystalline, colloidal zirconia particles, at least one soluble zirconium compound, solvent, and optionally one or more of :

(1) a water soluble compound or sol of metals whose oxides are phase stabilizers for zirconia wherein the metal oxides may be present in amounts up to 20 mole percent of the total oxide content, and wherein the phase stabilizers preferably can be at least of yttrium oxide, magnesium oxide, calcium oxide, and cerium oxide ;

(2) a water soluble compound or sol of metals whose oxides are grain growth inhibitors or tougheners for zirconia and wherein the metal oxide comprises a second phase up to 25 volume percent of the total oxides present and wherein the grain growth inhibitor preferably can be aluminum oxide ;

(3) a water soluble organic polymer wherein said polymer comprises up to 50 wt. percent of the total oxide mass content of the fiber ;

(b) concentrating the mixture ;

(c) extruding or blowing the fiber to provide a green fiber ; and

(d) heating the green fiber to a temperature in the range of 400 to 2000°C in an oxygen-containing atmosphere to provide a ceramic fiber.

The method of making ceramic fibers from sols is well known and is described for example in U.S. Patent No. 4,166,147.

A number of other processes for the preparation of $ZrO_2$ based fibers are known. One method is the "relic process" as described in U.S. Patents 3,385,915 and 3,860,529. In the "relic process" the zirconium compound and compounds of any desired stabilizing oxides are impregnated into organic polymeric fabric or textile. The impregnated fabric or textile is then heated in an oxidizing atmosphere to volatilize the organic fabric or textile.

Other processes for preparing zirconia based fibers have also used solutions of zirconium compounds such as salts or alkoxides as zirconium sources. Such processes are described in U.K. Patent Nos. 1,030,232 and 1,360,197 ; U.S. Patent Nos. 3,180,741 ; 3,322,865 ; and 3,992,498 which are incorporated herein by reference. "Green" fibers are formed by spinning, drawing, blowing or extrusion. The green fibers are fired to volatilize and remove fugitives (i.e., water, organics, and anions such as chloride or nitrate) from the fiber and to form zirconium oxide. In these processes a solution of soluble zirconium salts, additives, and modifiers is concentrated, typically by warming under a reduced pressure in a rotary evaporator to produce a highly viscous fiberizable dope.

The preferred high temperature ceramic oxide superconductors are members of the systems :

1) A-(Ba,D)-Cu-O ; and

2) (Bi,E)-Sr-Ca-Cu-O

wherein

A can be at least one element selected from the group consisting of Y, Pr, Nd, Sm, Eu, Gd, Tb, Dy, Ho, Er, La, and Yb ;

D can be none or at least one element selected from the group consisting of Sr and Ca ; and

E can be none or at least one element selected from the group consisting of Pb and Sb.

It is recognized by one skilled in the art that the ratio of components present in a high temperature ceramic oxide superconductor may not correspond exactly to a specific phase. In such cases, a plurality of phases may result which may include both superconducting and non-superconducting phases. The ratio of the components, however, needs to be such that at least one high temperature ceramic oxide superconductor phase is formed.

The preferred high temperature ceramic oxide superconductor phases within the A-(Ba,D)-Cu-O and (Bi,E)-Sr-Ca-Cu-O systems include $Y_1Ba_2Cu_3O_7$ and $Bi_2Sr_2Ca_1Cu_2O_8$ and $Bi_4Sr_3Ca_3Cu_4O_{16}$. Other examples include $Bi_2Sr_2Ca_2Cu_3O_{10}$ and $Y_2Ba_4Cu_7O_{15}$. The high temperature ceramic oxide superconductor phases indicated by the chemical formulas above and herein, may exhibit slight variations in the exact ratios of the components, particularly as regards the oxygen content of a given phase or compound. $Y_1Ba_2Cu_3O_7$, for example, is known in the art to contain 6.0 to 7.0 moles of oxygen per mole of formula units. Use of the chemical formulas above and herein is not intended to exclude phases or compounds exhibiting minor deviations in stoichiometry with respect to the ideal formula.

Other high temperature ceramic oxide superconductors which can be useful in the present invention include members of the systems :

1) (Tl,G)-(Ba,J)-Ca-Cu-O ; and

2) (La,L)-Cu-O

wherein

G can be none or at least one element selected from the group consisting of Pb and Bi ;

J can be none or the element Sr ; and

L can be at least one element selected from the group consisting of Sr and Ba.

It is recognized by one skilled in the art that the ratios of components present in a high temperature ceramic oxide superconductor may not correspond exactly to a specific phase. In such cases, a plurality of phases may result which may include both superconducting and non-superconducting phases. The ratio of the components need to be such that at least one high temperature ceramic oxide superconductor phase is formed.

Examples of high temperature ceramic oxide superconductor phases in the (Tl,G)-(Ba,J)-Ca-Cu-O system wherein non-oxygen components, (Tl,G), (Ba,J), Ca, Cu, are present in the ratios of 2 : 2 : 1 : 2, 2 : 2 : 2 : 3, 1 : 2 : 2 : 2, 1 : 2 : 2 : 3, 1 : 2 : 3 : 4, 2 : 1 : 2 : 2, and 2 : 3 : 2 : 4. G and J are as defined above. Examples of high temperature ceramic oxide superconductor phases within the (La,L)-Cu-O system include : $(La,Sr)_2CuO_4$ and $(La,Ba)_2CuO_4$.

High temperature ceramic oxide superconductor phases can be used individually or in combination.

Any method known in the art can be used to deposit a high temperature ceramic oxide superconductor thin film on a zirconia fiber core. The preferred coating methods for preparing the composite article of the present invention are : electron beam co-evaporation, cylindrical magnetron sputtering, and dip coating. These coating methods can be used to coat a single zirconia fiber or a bundle thereof.

A method for coating a thin film of a high temperature ceramic oxide superconductor by electron beam co-evaporation is described by B. Oh et al. in "Critical Current Densities and Transport in Superconducting $YBa_2Cu_3O_{7-\delta}$ Films Made by Electron Beam Co-Evaporation", <u>Appl. Phys. Lett.</u> <u>51</u>, (11), Sept. 14, 1987, pp. 852-854, incorporated herein by reference. Preferably, in the present invention, a 1 : 2 : 3 ratio of metallic Y, Ba, Cu, respectively, is evaporated onto zirconia fiber(s) using a three-gun electron beam co-evaporation process. The coated fiber(s) is then heated in oxygen for a time and at a temperature sufficient to produce a $Y_1Ba_2Ca_3O_7$ high temperature ceramic oxide superconductor. The preferred heat treatment temperature ranges from 400 to 1000°C. The sources can comprise any suitable precursors which can be electron beam heated and which do not splatter when heated by an electron beam. Examples of such precursors include yttrium oxide, yttrium, barium, barium oxide, barium fluoride, bismuth, bismuth oxide, strontium, copper, copper oxide, strontium carbonate, calcium, calcium carbonate, Sr-Ca alloys, Pb, Pb-Bi alloys, and thallium.

The coating of a high temperature ceramic oxide superconductor by sputtering is described by M. Hong et al. in "Superconducting Y-Ba-Cu-O Oxide Films by Sputtering", <u>Appl. Phys. Lett.</u>, <u>51</u>, (9), Aug. 31, 1987, pp. 694-696, incorporated herein by reference. Preferably, in the present invention, a $Y_1Ba_2Cu_3O_7$ high temperature ceramic oxide superconductor is deposited onto a zirconia fiber(s) using a cylindrical magnetron sputtering process. In this preferred method, a $YBa_2Cu_3O_7$ target (see Example 3 below) is sputtered to provide a thin film comprising amorphous $YBa_2Cu_3O_7$ on a zirconia fiber(s). The coated fiber(s) is then heated in an oxidizing atmosphere for a time and at a temperature sufficient to form a high temperature ceramic oxide superconductor. In another preferred method, the same process is used to deposit $Bi_4Sr_3Ca_3Cu_4O_{16}$ onto a zirconia fiber(s). In this method, $Bi_4Sr_3Ca_3Cu_4O_{16}$ (see Example 4 below) is sputtered to provide a thin film of $Bi_4Sr_3Ca_3Cu_4O_{16}$ on a zirconia fiber(s). The coated fiber(s) is then heated in an oxidizing atmosphere for a time and at a temperature sufficient to form a high temperature ceramic oxide superconductor. The preferred heat treatment temperature ranges from 400 to 1000°C. The target can comprise powders, powders with binders, and metals which are precursors of a high temperature ceramic oxide superconductor, as well as sintered high temperature ceramic oxide superconductors themselves. Examples of such materials include barium, barium oxide, barium fluoride, copper, copper oxide, bismuth, bismuth oxide, yttrium, yttrium oxide, Pb, Bi-Pb compounds, strontium, calcium, Sr-Ca compounds, strontium carbonate, calcium carbonate, thallium, Y-Ba-Cu-O compounds, and Bi-Sr-Ca-Cu-O compounds. Target geometries useful in preparing the article of the present invention include, for example, planar and annular.

The coating of a high temperature ceramic oxide superconductor by applying liquid precursors is described by H. Nasu et al. in "High $T_c$ Superconducting $Ba_2YCu_3O_x$ Films Prepared by Pyrolysis of Organic or Inorganic Acid Salts", <u>Seramikkusu Ronbunshi</u>, <u>96</u>, (6), 1988, pp. 710-713. Preferably, in the present invention a thin film of a liquid precursor of a high temperature ceramic oxide superconductor is applied to a zirconia fiber(s) by dip coating. The thin film is then pyrolyzed and heated in an oxidizing atmosphere for a time and at a temperature sufficient to form a high temperature ceramic oxide superconductor. Optionally, the liquid precursor is dried prior to pyrolyzing. More preferably, the dipping, drying, and pyrolyzing steps are repeated up to 100 times in order to provide a thin film thickness within the preferred, more preferred, or most preferred range. Again, optionally the liquid precursor is dried prior to pyrolyzing.

The liquid precursor can be any chemical precursor of a high temperature ceramic oxide superconductor dissolved or suspended in a liquid, provided the precursor(s) and liquid are mutually soluble and stable, and can be applied, dried, pyrolyzed, and heated to form a continuous thin film of a high temperature ceramic oxide superconductor. Preferably, the liquid precursor can be a solution of soluble compounds (e.g., simple salts) or a suspension of colloidal particles in a liquid such as, for example, water or an alcohol. A preferred liquid precursor comprises yttrium, barium, and copper trifluoroacetates dissolved in methanol. More preferably a liquid precursor comprises copper and strontium acrylates and bismuth and calcium nitrates in methoxyethanol. Other liquid precursors useful in preparing the article of the present invention by dip coating include, for example, bismuth, strontium, calcium and copper nitrates dissolved in a liquid comprising ethylene glycol and citric acid or methanol and acetic acid ; yttrium, barium, and copper neodecanoates, 2-ethylhexanoates, or naphthanates, dissolved in toluene ; or any other suitable chemical precursor dissolved or suspended in liquid. Preferably the concentration of the liquid precursor ranges from 0.001 to 3 moles of cations or metal atoms per kilogram of solution. More preferably, the concentration of the liquid precursor ranges from 0.1 to 0.5 moles of cations or metal atoms per kilogram of solution.

The preferred pyrolyzing temperature ranges from 350 to 650°C. The preferred heat treatment temperature for the Y-Ba-Cu-O and Bi-Sr-Ca-Cu-O based superconductors is in the range of 850 to 1000°C and 750 to 900°C, respectively.

Other coating methods useful in preparing the composite article of the present invention include methods known in the art such as, for example, chemical vapor deposition, laser deposition, and evaporation from resistively-heated sources.

At least four factors are important in determining the suitability of a substrate for a wire-like high temperature ceramic oxide superconductor : chemical compatibility, thermal compatibility, crystallographic compatibility, and substrate geometry. A substrate and high temperature ceramic oxide superconductor should be chemically compatible such that the diffusion of chemical species between the substrate and the high temperature ceramic oxide superconductor during processing is not sufficient to substantially affect the superconducting properties, strength, or flexibility of the composite article.

It is desirable that a substrate and a high temperature ceramic oxide superconductor be thermally compatible such that their thermal expansion coefficients are sufficiently similar to prevent cracking or spalling during heating or cooling. A substrate and a high temperature ceramic oxide superconductor should be crystallographically compatible such that the lattice parameters (i.e., atomic spacing) and crystal structure of the substrate can promote formation of a high temperature ceramic oxide superconductor phase.

It is desirable that a substrate used to form a wire-like composite be of fine diameter (e.g., 5 to 60 micrometers) and equi-axed in cross-section. Fine diameter fiber substrates have inherently less strain during flexure than do thicker sheet-like substrates. This lower strain reduces the possibility of cracking the coating. In addition, the geometry of the fibers allows winding or bending of the coated fibers in various directions, whereas a ribbon-like substrate cannot be bent easily in all directions.

The fiber also permits a high proportion of high temperature ceramic oxide superconductor to be coated thereon such that the resulting composite can have substantial flexibility. For example, a 1 micrometer thick superconductor thin film on a 5 micrometer diameter fiber yields a coating to substrate cross-sectional area ratio of about 0.96. On the other hand, a 1 micrometer thick coating on a conventional 25.4 micrometer thick sheet or ribbon-like substrate has a ratio of about 0.039. For a given critical current density, the higher the superconductor-to-substrate cross-sectional area ratio, the higher the current which can be carried in a given volume. A coated fiber construction having a fine diameter fiber core allows the use of high temperature ceramic oxide superconductors which are prohibited from use in a conventional substrate coating construction because of low critical current density.

The thickness of a high temperature ceramic oxide superconductor thin film can vary. Very thin films allow the composite article of the present invention to retain essentially the same flexibility as the original zirconia fiber, and require minimal film deposition times. Thicker films increase the ratio of superconductor to zirconia cross-sectional area, and exhibit electrical properties which are less affected by small amounts of interdiffusion between the thin film and the fiber. The optimum thickness range represents a compromise between the aforementioned factors. Preferably the thickness of the high temperature ceramic oxide superconducting thin film is in the range of greater than zero to $10^2$ micrometers, more preferably in the range of 0.1 to 10 micrometers, and most preferably in the range of 0.3 to 2 micrometers.

Zirconia fibers used in the present invention retain their flexibility even after completion of the processing necessary to deposit a high temperature ceramic oxide superconductor thin film onto the zirconia fiber. Preferably the composite article has sufficient flexibility to be wrapped in a circle around a 1 meter diameter rod without breaking, more preferably around a 2.5 centimeter diameter rod, even more preferably around a 5 millimeter diameter rod, and most preferably around a 2.3 millimeter diameter rod.

The composite article of the present invention exhibits an onset transition temperature of preferably greater than 23 K, more preferably greater than 77 K, and most preferably at least 95 K. An onset temperature of greater than 77 K is necessary to allow the use of liquid nitrogen rather than liquid helium to cool the composite article to where it begins to exhibit its superconducting properties. It is significantly cheaper to cool a material with liquid nitrogen than with liquid helium. Preferably the composite article of the present invention has a superconducting transition end point of at least 50 K.

The composite article of the present invention is useful for applications which require the transport or storage of electrical energy.

A particularly useful embodiment of the present invention comprises a bundle or tow of zirconia fibers preferably with a length greater than 1 centimeter, more preferably greater than 1 meter. A tow of sufficiently strong and fine diameter fibers is textile-like in character, which means that it can be flexed, woven, or coiled either before or after the deposition of a high temperature ceramic oxide superconductor thin film.

High temperature ceramic oxide superconductors may be susceptible to degradation by exposure to atmospheric components such as $H_2O$ and $CO_2$. A protective coating may be applied to the composite article of the present invention to prevent or minimize environmental damage to the superconducting properties of the article. The protective coating, which can range in thickness from greater than zero up to the diameter of the composite article, can comprise at least one metal wherein the metal can be, for example, silver, copper, aluminum, or niobium ; at least one polymer wherein the polymer can be, for example, a polyimide ; or at least one metal oxide wherein the metal oxide can be, for example, $ZrO_2$, $Al_2O_3$, or MgO. Metal coatings are particularly useful in that they provide thermal stability and current shunting in the event that a localized region of conductor becomes non-superconducting.

Another particularly useful embodiment of the present invention may comprise composite articles of the present invention embedded in an aligned manner within a wire-like metal-matrix structure to provide a low resistance or superconducting wire or wire-like article.

Objects and advantages of this invention are further illustrated by the following examples, but the particular materials and amounts thereof recited in these examples, as well as other conditions and details, should not be construed to unduly limit this invention.

## Example 1

A three-gun electron beam coating process was used to coevaporate elemental Y, Ba, and Cu in a 1 : 2 : 3 ratio. The electron beam apparatus included three electron guns, two with single pockets and one with four pockets. The gun hearths formed an isosceles triangle with the center of the triangle directly below a 2.5 cm by 7.6 cm (1″ × 3″) Cu-Ni alloy substrate holder. Each source was independently monitored with directional quartz crystal monitors (QCMs), resulting in no signal cross talk. The QCM outputs were used in a feedback loop to servo the source coating rates.

The source materials were prepared by melting the appropriate bulk metals with an electron beam. Metallic barium, metallic yttrium, and metallic copper were placed in separate carbon crucibles which served to hold the source material.

Zirconia fibers were prepared as described in assignee's copending patent application Serial No. 07/286,654 which method is incorporated herein by reference. The zirconia fibers comprised 4 weight percent $Y_2O_3$ and were fired at 1100°C. The diameters of the fibers were 10 to 25 micrometers.

Bundles of the fibers containing 50 to 500 fibers were cut to approximately 2.5 cm (1 inch) lengths. For each run, three to six of these fiber bundles were mounted onto a substrate mounting block which was positioned 35.6 cm (14 inches) above the electron gun hearths. The bundles were held in place with stainless steel clips at their ends, so that during coating only one side of the fibers faced the sources, resulting in coating on approximately half of the surface of each fiber. Glass substrates were placed directly adjacent to each bundle for compositional analysis. The substrate mounting block was heated by two 500 Watt quartz-halogen lamps mounted directly above it. The temperature of the fibers during coating was less than 410°C. A shutter system was used to shield the fibers from evaporant until the desired coating starting time. The coating chamber was evacuated by means of an oil diffusion pump assisted by a liquid nitrogen cold trap system. The base pressure achieved was approximately $4 \times 10^{-8}$ Torr. During coating, the maximum pressure was approximately $2 \times 10^{-5}$ Torr. Total coating rates ranged from 10 to 100 Å/sec. Typically, the individual coating rates used were : Y at a rate of 2.9 Å/sec., Ba at a rate of 9.0 Å/sec., and Cu at a rate of 2.5 Å/sec. Total coating time at these rates was approximately 28 minutes. The total coating thickness was about 1.5 micrometers.

Compositions were determined by Inductively Coupled Plasma Emission Spectroscopy. Fibers having a $Y_{0.87}Ba_{2.00}Cu_{3.05}O_7$ coating were heated for 30 minutes in a tube furnace with flowing oxygen using the following heating schedule :

27°C → 900°C at 20°C/minute
900°C hold for 30 minutes
900°C → 400°C at 4°C/minute
400°C → 250 to 27°C

Coated fibers were removed from the furnace at 250° or less and cooled to room temperature (i.e. 27°C). The heat treatment temperature was monitored by placing a thermocouple directly adjacent to the composite article.

Electrical resistivity measurements were made using a four point probe technique as described for example by X.D. Chen in "Practical Preparation of Copper Oxide Superconductors", Rev. Sci. Instrum., 58, (9), Sept., 1987, pp. 1565-1571.

The electrical resistance of single fibers coated with $Y_{0.87}Ba_{2.00}Cu_{3.05}O_7$ were measured to verify that conduction was continuous along individual coated fibers. A fiber was placed on an insulating (glass) surface with the ends of the fiber adhered to the probe with double-sided tape. Small quantities of silver paint were used to draw electrical contacts between the fiber and the wires from the current and voltage leads. The sample was cooled by immersion in the vapor above a liquid helium reservoir. A current of approximately 0.1 microamperes was applied to each coated fiber. The superconducting transition onset temperature was about 92 K.

The electrical resistivities of the bundles as a function of temperature were also measured using the same four point probe method. The superconducting transition onset temperatures of the bundles were also about 92 K.

## Example 2

A direct current cylindrical-hollow magnetron was used to coat a tow of 10 cm-long zirconia fibers with $Y_{1.10}Ba_{2.00}Cu_{3.01}O_7$. The fibers were prepared as in Example 1. A cylindrical-hollow magnetron was mounted in a cryo-pumped vacuum system with a base pressure of $5 \times 10^{-8}$ Torr. A magnetron cylinder, which was about 10.1 cm (4 inches) in diameter and 7.6 cm (3 inches) long, was surrounded by eight permanent magnets to provide electron confinement in a circular path within the middle of the cylinder. An annular anode plate was mounted at one end of the cylinder for collection of electrons.

A sputtering target comprising $Y_1Ba_2Cu_3O_7$ powder was prepared using techniques as described, for example, by Hyde et al. in "The Room Temperature Structure of the $\sim$ 90-K Superconducting Phase $YBa_2Cu_3O_{7-x}$", Nature, 327, June, 1987, pp. 402-403. The starting materials were $Y_2O_3$, $BaCO_3$, and $CuO$ powders.

The sputtering target which was attached to a copper sleeve was inserted into the cylindrical cathode and made good electrical and thermal contact to the cathode. The target had an outside diameter of 10.1 cm (4 inches) and an inside diameter of 9.9 cm (3.9 inches).

The magnetron cylinder was mounted with its axis vertical and a fiber drive system was used to pull a tow of fibers up through the anode plate and through the cylinder. The sputtering system was operated at between 100 and 300 W and at an Ar pressure of $10^{-2}$ Torr. The coating rates ranged from 40 to 80 Å/sec. The coating thickness was about 0.5 micrometers.

The tow of fibers was then heated at 875°C for one hour in an oxygen atmosphere. A fiber from the tow with a 14 micrometer composite diameter was wrapped in a circle around a rod 2.3 millimeter in diameter without breaking the composite.

The electrical resistivity of the coated fibers was measured using the same technique used in Example 1. The superconducting transition onset temperature was about 87 K.

## Example 3

Ten cm-long zirconia fibers comprising 7 weight percent $Y_2O_3$ fired at 1040°C were prepared as in Example 1. The procedures in Example 2 were repeated to coat a thin film of $Y_{0.91}Ba_{2.00}Cu_{2.72}O_7$ onto the fibers.

The coated fibers were heat treated at 875°C for 1 hour. A fiber from the bundle was bent through a 6.4 millimeter diameter arc without breaking the composite.

The electrical resistivity of the fibers were measured using the same technique used in Example 1. The superconducting transition onset temperature was about 89 K.

## Example 4

Zirconia fibers, 10-cm long, were prepared as in Example 1. The procedures in Example 2 were repeated using a $Bi_4Sr_3Ca_3Cu_4O_{16}$ sputtering target. The target comprised $Bi_4Sr_3Ca_3Cu_4O_{16}$ powder. The powder was prepared using techniques described, for example, by J.M. Tarascon, et al. in "Preparation, Structure, and Properties of the Superconducting Compound Series $Bi_2Sr_2Ca_{n-1}Cu_nO_y$ with n = 1, 2, and 3", Phys. Rev. B., 38, (13), Nov. 1, 1988, pp. 8885-8892. The starting materials were $Bi_2O_3$, $SrCO_3$, $CaCO_3$, and $CuO$ powders.

A 1.5 micrometer coating of $Bi_4Sr_{3.12}Ca_{3.21}Cu_{4.88}O_{16}$ was sputtered onto a tow of zirconia fibers and then heated in an oxygen atmosphere as described in Example 2 at 850°C for 2 hours.

A fiber with a 21 micrometer composite diameter was bent in a 1 cm diameter arc without the composite breaking.

The superconducting transition onset temperature as determined using the four point resistivity probe described in Example 1 was about 85 K.

## Example 5

A dip coating method was used to coat a thin film of $Bi_2Sr_2CaCu_2O_8$ on a bundle of zirconia fibers. The 10.2 cm (4 inch) long fibers were prepared as in Example 1.

A precursor solution comprising copper acrylate, strontium acrylate, calcium nitrate, and bismuth nitrate in methoxyethanol was prepared, with a Bi : Sr: Ca : Cu ratio of 2 : 2 : 1 : 2, with a total cation concentration of 1 mole per Kg of solution. A 0.5 molal aqueous solution of copper acrylate and a 0.5 molal aqueous solution of strontium acrylate were prepared by reacting the requisite amounts of SrO and $CuCO_3.Cu(OH)_2$ with acrylic acid.

Non-aqueous solutions were formed by diluting each with 2 parts methoxyethanol and concentrating to the original volume with a rotary evaporator. This dilution-concentration step was repeated once.

Solutions of 0.5 molal bismuth nitrate and calcium nitrate solutions were prepared by dissolving the requisite amount of nitrate powders in methoxyethanol. Approximately 25 volume percent of each solution was removed by rotary evaporation to eliminate water originating as crystalline water in the nitrate salts.

Solutions were combined to give a Bi : Sr : Ca : Cu ratio of 2 : 2 : 1 : 2. The resulting solution was then concentrated by rotary evaporation to give 1 mole of total cations per kg of solution. The solution was diluted to 12.5% of the original concentration with methanol and poured into a vial for dipping.

A bundle of fibers was dipped in the precursor solution and blotted on filter paper to remove excess liquid. The remaining coating was pyrolyzed in air by placing it in a box furnace preheated to 550°C. The bundle was flexed by hand to separate bridged areas. After 5 to 10 dipping and heating cycles, the fibers were dark gray to black in color.

After 60 dipping and heating cycles, the bundle was heated in air at 825°C for 3 hours. The resulting bundle of coated fibers was generally black in color, with yellowish tinges near the center of the bundle. The thickness of the high temperature ceramic oxide superconductor coated on the fibers ranged from 0.5 to 3 micrometers. The fired bundle had occasional bridged areas. A 2.5 cm (1 inch) section of the bundle of coated fibers was bent into a 2.5 cm diameter arc with little or no breakage.

A portion of the bundle was mounted onto a thin alumina plate with four evenly spaced drops of silver conductor paint.

The superconducting onset transition temperature as determined using the four point resistivity probe described in Example 1 was about 95 K. At 50 K there was zero electrical resistance.

Example 6

The dip coating method described in Example 5 was used to coat $Y_1 Ba_2 Cu_3 O_7$ onto zirconia fibers. The 7.6 cm (3 inch) long fibers were prepared as in Example 1.

A $Y_1 Ba_2 Cu_3 O_7$ precursor solution was prepared from solutions of yttrium, barium, and copper trifluoroacetates. A 0.5 molal aqueous solution of yttrium trifluoroacetate, a 0.5 molal aqueous solution of barium trifluoroacetate and a 0.5 molal aqueous solution of copper trifluoroacetate were prepared by reacting the requisite amount of yttrium oxide, barium carbonate, or copper metal, with trifluoroacetic acid. Hydrogen peroxide was added drop-wise to the copper/trifluoroacetic acid mixture until a clear blue solution was obtained. Each of the solutions were evaporated to dryness. The resulting solids were separately re-dissolved in methanol. Portions of the three solutions were then combined in the appropriate ratio to yield a precursor solution with a Y : Ba : Cu ratio of 1 : 2 : 3.

A bundle of zirconia fibers was coated by repeatedly dipping the bundle into the precursor solution. The coated fiber bundle was blotted dry on filter paper. The bundle was pyrolyzed after each coating as described in Example 5. The bundle was then fired in water saturated oxygen at 850°C for 75 minutes and then heated in dry oxygen at 910°C for 30 minutes. The resulting coated fibers were black. The thickness of the high temperature ceramic oxide superconductor coated onto the fibers ranged from 0.5 to 3 micrometers. The bundle of fibers was wrapped in a circle around a 5 millimeter diameter rod several times with little or no fiber breakage.

Various modifications and alterations of this invention will become apparent to those skilled in the art without departing from the scope and spirit of this invention, and it should be understood that this invention is not to be unduly limited to the following illustrative embodiments set forth herein.

Claims

1.  A composite article comprising a fiber core comprising crystalline zirconia and coated on at least a portion of said core a thin film of a high temperature ceramic oxide superconductor.

2.  The composite article according to claim 1 wherein the diameter of said fiber core ranges from 5 to 60 micrometers.

3.  The composite article according to any preceeding claim wherein said fiber core further comprises at least one metal oxide selected from the following group consisting of yttrium oxide, magnesium oxide, calcium oxide, cerium oxide, and aluminum oxide.

4.  The composite article according to any preceeding claim wherein said thin film exhibits a superconducting transition onset at a temperature greater than 77 K.

5.  The composite article according to any preceeding claim wherein said thin film exhibits a superconducting transition end point of at least 50 K.

6.  The composite article according to any preceeding claim wherein said high temperature ceramic oxide superconductor comprises at least one compound from at least one of the systems consisting of A-(Ba, D)-Cu-O, (Bi, E)-Sr-Ca-Cu-O, (Tl, G)-(Ba-J)-Ca-Cu-O, or (La, L)-Cu-O wherein A is at least one element selected from the group consisting of Y, Pr, Nd, Sm, Eu, Gd, Tb, Dy, Ho, Er, La, and Yb ; D is none or at least one element selected from the group consisting of Sr and Ca; E is none or at least one element selected from the group consisting of Pb and Sb ; G is none or at least one element selected from the group consisting of Pb and Bi ; J is none or the element Sr; and L is at least one element selected from the group consisting of Sr and Ba, and wherein said components are present in proportions which provide at least one high temperature ceramic oxide superconductor phase.

7.  The composite article according to any preceeding claim wherein said high temperature ceramic oxide superconductor comprises $Y_1Ba_2Cu_3O_7$, $Bi_4Sr_3Ca_3Cu_4O_{16}$, or $Bi_2Sr_2Ca_1Cu_2O_8$.

8.  The composite article according to any preceeding claim wherein said article further comprises an environmental protective coating overlying said thin film or wherein said composite article is embedded in a metal to provide a metal-matrix structure.

9. The composite article according to any preceeding claim wherein said composite article is prepared by

(1) a method comprising the steps of

a) applying a thin film of a high temperature ceramic oxide superconductor precursor(s) onto at least a portion of a bundle of crystalline zirconia fibers, and

b) heating said fibers in an oxidizing atmosphere at 400 to 1000°C ; or

(2) a method comprising the step of depositing a thin film of a high temperature ceramic oxide superconductor onto at least a portion of a bundle of crystalline zirconia fibers ; or

(3) a method comprising the steps of

a) applying a liquid precursor of a high temperature ceramic oxide precursor(s) onto at least a portion of a crystalline zirconia fiber,

b) optionally drying said liquid precursor,

c) pyrolyzing said precursor in the range of 350 to 650°C,

d) optionally repeating steps a-c up to 100 times, and

e) heating the resulting composite in the range of 750 to 1000°C in an oxidizing atmosphere to provide said fiber having thereon a thin film of said high temperature ceramic oxide superconductor.

10. The composite article according to claim 9 wherein step (a) of method (1) comprises evaporating or sputtering said high temperature ceramic oxide superconductor precursor(s) onto said bundle of crystalline zirconia fibers, and wherein step (a) of method (2) comprises evaporating or sputtering said high temperature ceramic oxide superconductor onto said bundle of crystalline zirconia fibers.

## EP 0 431 782 A1

**European Patent Office**

# EUROPEAN SEARCH REPORT

Application Number

EP 90 31 2527

Page 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| P,X | EP-A-354616 (PHILIPS PATENTVERWALTUNG GMBH)<br>* the whole document * | 1, 4-7, 9 | C04B35/00<br>H01L39/24<br>B32B18/00 |
| P,X | EP-A-385132 (SUMITOMO ELECTRIC INDUSTRIES)<br>* the whole document * | 1, 3-7, 9-10 | |
| P,Y | | 8 | |
| D,Y | EP-A-318651 (KERNFORSCHUNGSZENTRUM KARLSRUHE GMBH)<br>* claim 3 * | 8 | |
| D,A | * column 2, lines 18 - 55; claims 1-2, 4 * | 1-7, 9-10 | |
| X | EP-A-304061 (SUMITOMO ELECTRIC INDUSTRIES)<br>* column 1, line 40 - column 3, line 10; claims 1-11, 17-18; figures 1, 2B, 6, 11 * | 1-10 | |
| X | EP-A-287258 (AMERICAN TELEPHONE AND TELEGRAPH COMPANY)<br>* column 7, line 6 - column 9, line 12; claims 1-2, 6-10 * | 1, 4-7, 9 | |
| | | | **TECHNICAL FIELDS SEARCHED (Int. Cl.5 )** |
| X | EP-A-321813 (ASEA BROWN BOVERI)<br>* the whole document * | 1, 3-7, 9-10 | C04B<br>B32B |
| X | EP-A-280292 (SUMITOMO ELECTRIC INDUSTRIES)<br>* column 1, line 28 - column 6, line 4; claims 1-20 * | 1-7, 9-10 | H01L |
| X | EP-A-292967 (TORAY INDUSTRIES INC.)<br>* page 6, lines 15 - 31; claims 1-16 * | 1, 3-7, 9-10 | |

The present search report has been drawn up for all claims

| Place of search | Date of completion of the search | Examiner |
|---|---|---|
| BERLIN | 13 MARCH 1991 | KUEHNE H.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

11

European Patent
Office

## EUROPEAN SEARCH REPORT

Application Number

EP    90 31 2527
Page 2

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | CHEMICAL ABSTRACTS, vol. 110, no. 8, 17 April 1987 Columbus, Ohio, USA N. TSUTOMU ET AL.: "Preparation of high transition temperature superconducting films by RF sputtering." page 318; ref. no. 140270C & Hyomen Kagaku, vol. 9, no. 7, 1988, Japan, pages 535-540 * abstract * | 1, 3-7, 9-10 | |
| D,A | APPLIED PHYSICS LETTERS. vol. 51, no. 11, 14 September 1987, NEW YORK US pages 852 - 854; B. OH ET AL.: "Critical current densities and transport in superconducting YBa2Cu3O7-delta films made by electron beam coevaporation." * the whole document * | 1-7, 9-10 | |
| D,A | EP-A-303412 (AMOCO CORPORATION) * the whole document * | 1 | |
| D,A | EP-A-290127 (VARIAN ASSOCIATES INC.) * the whole document * | 9-10 | TECHNICAL FIELDS SEARCHED (Int. Cl.5) |
| P,A | EP-A-375158 (MINNESOTA MINING AND MANUFACTURING COMPANY) * the whole document * | 1 | |
| D,P, A | & US-A-4937212 | | |

The present search report has been drawn up for all claims

| Place of search | Date of completion of the search | Examiner |
|---|---|---|
| BERLIN | 13 MARCH 1991 | KUEHNE H.C. |

EPO FORM 1503 03.82 (P0401)